# EUROPÄISCHE PATENTSCHRIFT

(11) **EP 4 434 060 B1**
(45) Veröffentlichungstag und Bekanntmachung des Hinweises auf die Patenterteilung: **04.11.2026**
(21) Anmeldenummer: 23725701.9
(22) Anmeldetag: 09.05.2023
(51) Int. Cl.: H01C 1/142, H01C 1/148, H01C 17/00, H01C 17/28, H01C 7/00, H01C 17/07, H01C 1/14, G01R 1/20, G01R 3/00

(54) **HERSTELLUNGSVERFAHREN FÜR EINEN ELEKTRISCHEN WIDERSTAND UND EIN ELEKTRISCHER WIDERSTAND**
MANUFACTURING PROCESS FOR AN ELECTRICAL RESISTOR AND AN ELECTRICAL RESISTOR
PROCÉDÉ DE FABRICATION D'UNE RÉSISTANCE ÉLECTRIQUE ET UNE RÉSISTANCE ÉLECTRIQUE

(30) Priorität: 30.05.2022 DE 102022113553
(43) Veröffentlichungstag der Anmeldung: 25.09.2024
(73) Patentinhaber: Isabellenhütte Heusler GmbH & Co. KG, 35683 Dillenburg (DE)
(72) Erfinder: DEGEN, Stefan, 35576 Wetzlar (DE)
(74) Vertreter: v. Bezold & Partner Patentanwälte - PartG mbB
(86) Internationale Anmeldenummer: PCT/EP2023/062318
(87) Internationale Veröffentlichungsnummer: WO 2023/232407

(56) Entgegenhaltungen:
- EP-A1- 3 726 542
- EP-B1- 3 451 352
- US-A1- 2006 273 423
- US-A1- 2008 224 818
- US-A1- 2009 322 467
- US-B2- 10 692 633

## Beschreibung

### Technisches Gebiet der Erfindung

Die Erfindung betrifft ein Herstellungsverfahren für einen elektrischen Widerstand, insbesondere für einen niederohmigen Strommesswiderstand.

### Hintergrund der Erfindung

Aus WO 2008/055582 A1 (US 2009/322467 A1) sind ein niederohmiger Strommesswiderstand ("Shunt") und ein Herstellungsverfahren für einen solchen Strommesswiderstand bekannt. Hierbei erfolgt im Rahmen des Herstellungsverfahrens ein Abgleich ("Trimmen") des Widerstandswerts, damit der fertige Strommesswiderstand einen vorgegebenen Widerstandswert möglichst exakt einhält. Dieser Widerstandsabgleich erfolgt üblicherweise durch Einbringen eines Trimmschnitts in das Widerstandselement des Strommesswiderstands, wobei der Trimmschnitt in Abhängigkeit von seiner Größe und seiner Lage den Widerstandswert des Strommesswiderstands beeinflusst. Dieses bekannte Verfahren zum Abgleich des Widerstandswerts eines Strommesswiderstands weist jedoch verschiedene Nachteile auf.

Zum einen lassen sich auf diese Weise nur schwer Widerstandswerte mit einer sehr geringen Toleranz von <0,5% realisieren.

Zum anderen führen die Einschnitte in dem Widerstandselement des Strommesswiderstands zu einer Verzerrung der Stromverteilung in dem Widerstandselement, was im Betrieb aufgrund der elektrischen Verlustwärme zu lokalen Temperaturüberhöhungen (Hot-Spots) in dem Widerstandselement führen kann. Derartige lokale Temperaturüberhöhungen können die Messgenauigkeit beeinträchtigen, da der spezifische elektrische Widerstand des Widerstandsmaterials des Widerstandselements temperaturabhängig ist.

Ein weiterer Nachteil der bekannten Art des Widerstandsabgleichs besteht darin, dass der Einschnitt in dem Widerstandselement eine mechanische Schwachstelle bildet, was bei thermischer Belastung durch Ausdehnung und Stauchung im Extremfall zu einer Rissbildung führen kann.

Ebenfalls ein Nachteil der bekannten Arten des Widerstandsabgleichs ist, dass ein unterschiedlicher Materialabtrag zum Widerstandsabgleich zu Schwankungen des thermischen Innenwiderstands von Bauteil zu Bauteil führt. Dies ist beim Abgleich über die Variation des Kontaktabstands nicht der Fall.

Darüber hinaus benötigt der Einschnitt in dem Widerstandselement zusätzlichen Platz, was einer Minimierung der Bauteilgröße des Strommesswiderstands Grenzen setzt.

Ferner kann das Einbringen des Einschnitts in das Widerstandselement auch zu Ausschuss führen, wenn die Stromesswiderstände nach dem Einbringen des Einschnitts Bearbeitungsspuren oder Rückstände zeigen.

Zum technischen Hintergrund der Erfindung ist auch hinzuweisen auf CN 111 192 733 A1, US 2006/273423 A1, EP 3 451 352 A1 und DE 30 27 122 A1.

Die vorstehend bereits erwähnte Veröffentlichung US 2009/0322467 A1 offenbart ein Herstellungsverfahren gemäß dem Oberbegriff von Anspruch 1. Dieses bekannte Herstellungsverfahren ist jedoch noch nicht vollständig befriedigend.

Der Erfindung liegt deshalb die Aufgabe zugrunde, ein entsprechend verbessertes Herstellungsverfahren anzugeben.

### Beschreibung der Erfindung

Diese Aufgabe wird durch ein erfindungsgemäßes Herstellungsverfahren gemäß dem Hauptanspruch gelöst.

Das erfindungsgemäße Herstellungsverfahren stimmt teilweise mit dem bekannten Herstellungsverfahren überein, wie es in WO 2008/055582 A1 beschrieben ist, so dass der Inhalt dieser Druckschrift der vorliegenden Beschreibung hinsichtlich der einzelnen Schritte des Herstellungsverfahrens in vollem Umfang zuzurechnen ist.

Das erfindungsgemäße Herstellungsverfahren sieht zunächst in Übereinstimmung mit dem Stand der Technik vor, dass ein flächiges Trägerelement - vorzugsweise aus einem elektrisch leitfähigen Leitermaterial - bereitgestellt wird, wobei das Trägerelement eine Oberseite und eine Unterseite aufweist.

Bei dem Leitermaterial kann es sich beispielsweise um Kupfer handeln, jedoch ist die Erfindung hinsichtlich des Leitermaterials nicht auf Kupfer beschränkt, sondern beispielsweise auch mit einer Kupferlegierung, Aluminium oder einer Aluminierlegierung als Leitermaterialien realisierbar.

Weiterhin ist zu erwähnen, dass das Trägerelement vorzugsweise aus einer Folie (z.B. Kupferfolie) besteht, jedoch ist die Erfindung hinsichtlich der Form des Trägerelements nicht auf Folien beschränkt, sondern beispielsweise auch mit plattenförmigen Trägerelementen realisierbar.

Ferner sieht auch das erfindungsgemäße Herstellungsverfahren in Übereinstimmung mit dem Stand der Technik vor, dass ein flächiges Widerstandselement aus einem Widerstandsmaterial bereitgestellt wird.

Bei dem Widerstandsmaterial handelt es sich beispielsweise um eine niederohmige Widerstandslegierung, wie beispielsweise eine Kupfer-Mangan-Nickel-Legierung. Die Erfindung ist jedoch hinsichtlich des Widerstandsmaterials nicht auf ein bestimmtes Widerstandsmaterial beschränkt. Allerdings sollte das Widerstandsmaterial einen größeren spezifischen elektrischen Widerstand aufweisen als das Leitermaterial des Trägerelements.

Weiterhin ist zu erwähnen, dass das flächige Widerstandselement vorzugsweise aus einer Widerstandsfolie besteht. Die Erfindung ist jedoch hinsichtlich der Form des Widerstandselements nicht auf Folien beschränkt, sondern beispielsweise auch mit plattenförmigen Widerstandselement realisierbar.

Das erfindungsgemäße Herstellungsverfahren sieht ferner in Übereinstimmung mit dem Stand der Technik vor, dass das flächige Widerstandselement flächig auf die Oberseite des flächigen Trägerelements aufgebracht wird und zwar vorzugsweise mit einer elektrisch isolierenden Schicht zwischen dem flächigen Widerstandselement einerseits und dem flächigen Trägerelement andererseits.

Beispielsweise kann es sich bei der elektrisch isolierenden Schicht zwischen dem flächigen Widerstandselement und dem flächigen Trägerelement um eine Klebstoffschicht handeln, die somit zwei Funktionen erfüllt, nämlich zum einen die mechanische Verbindung zwischen dem Trägerelement und dem Widerstandselement und zum anderen die elektrische Isolation zwischen dem Trägerelement und dem Widerstandselement.

Ferner sieht das erfindungsgemäße Herstellungsverfahren dann in Übereinstimmung mit dem Stand der Technik vor, dass das flächige Widerstandselement durch zwei Kontaktkappen elektrisch kontaktiert wird, wobei die beiden Kontaktkappen zur elektrischen Kontaktierung des fertigen Widerstands dienen. Die Kontaktkappen bestehen deshalb aus einem elektrisch leitfähigen Leitermaterial. Beispielsweise können die Kontaktkappen aus Kupfer bestehen und eine Beschichtung aus Zinn aufweisen. Die Kontaktkappen müssen jedoch nicht notwendigerweise aus demselben Leitermaterial bestehen wie das Trägerelement.

Hierbei ist zu erwähnen, dass die Kontaktkappen an der Oberseite des Widerstandselements unmittelbar aufliegen und sich bezüglich der Stromflussrichtung in dem Widerstand einander gegenüberliegen. In dem fertigen Widerstand fließt der zu messende Strom also durch die eine Kontaktkappen in den Widerstand hinein, strömt dann durch das Widerstandselement und verlässt den Widerstand wieder durch die andere Kontaktkappe.

Hierbei ist auch zu erwähnen, dass unmittelbar auf der Oberseite des flächigen Widerstandselements ein bestimmter Abstand zwischen den beiden Kontaktkappen besteht, wobei dieser Abstand den Widerstandswert des fertigen Widerstands beeinflusst. So definiert der Abstand zwischen den beiden Kontaktkappen an der Oberseite des Widerstandselements die Länge des Stromwegs durch das Widerstandselement und damit auch den Widerstandswert des fertigen Widerstands. Dieser technisch-physikalische Zusammenhang wurde jedoch bisher im Stand der Technik nicht zum Abgleich des Widerstandswerts des Widerstands ausgenutzt.

Darüber hinaus sieht auch das erfindungsgemäße Herstellungsverfahren vor, dass ein gewünschter Widerstandswert für den Widerstand vorgegeben wird, der dann bei dem Widerstandsabgleich berücksichtigt wird.

Die Erfindung zeichnet sich nun jedoch durch eine besondere Art des Widerstandsabgleichs vor. Im Rahmen der Erfindung wird nämlich zum Abgleich des Widerstandswerts der Abstand zwischen den Kontaktkappen unmittelbar an der Oberseite des Widerstandselements eingestellt, wobei der Abstand in Abhängigkeit von dem gewünschten Widerstandswert eingestellt wird. Hierzu kann in Versuchen zunächst ermittelt werden, welcher Zusammenhang zwischen dem Abstand zwischen den Kontaktkappen einerseits und dem resultierenden Widerstandswert andererseits besteht. Im Rahmen des erfindungsgemäßen Widerstandsabgleichs kann dieser Zusammenhang dann genutzt werden, um den Abstand zwischen den Kontaktkappen entsprechend einzustellen. Die Erfindung benötigt also zum Widerstandsabgleich keinen Einschnitt mehr in dem Widerstandselement, so dass die eingangs beschriebenen Nachteile vermieden werden. So lassen sich mit dem erfindungsgemäßen Verfahren zum Widerstandsabgleich kleinere Toleranzen von <0,5% erreichen und die im Stand der Technik störenden Temperatur-Hotspots lassen sich vermeiden.

Gemäß der Erfindung ist vorgesehen, dass unmittelbar auf die Oberseite des Widerstandselements vor der Kontaktierung durch die Kontaktkappen Lötstopplack aufgebracht wird, wobei der Lötstopplack nur eine bestimmte Ausdehnung entlang der Stromflussrichtung in dem Widerstand aufweist und an den gegenüberliegenden Enden Streifen für die Kontaktkappen frei lässt. Die Ausdehnung des Lötstopplacks entlang der Stromflussrichtung definiert dann den späteren Abstand zwischen den Kontaktkappen an der Oberseite des Widerstandselements und damit auch die Länge des Stromwegs durch das Widerstandselement. Anschließend werden dann erst die Kontaktkappen auf die Oberseite des flächigen Widerstandselements aufgebracht, wobei die Kontaktkappen dann den Abstand zwischen sich einschließen, der zuvor durch den Lötstopplack eingestellt wurde. Das Aufbringen der Kontaktkappen kann hierbei also mit relativ groben Positionierungstoleranzen erfolgen, da die Genauigkeit des Abstands zwischen den Kontaktkappen durch die Ausdehnung des zuvor aufgebrachten Lötstopplacks definiert wird.

Ferner ist zu erwähnen, dass auch auf die Unterseite des flächigen Trägerelements zwischen den Kontaktkappen ein Lötstopplack aufgebracht werden kann, wie es an sich aus dem Stand der Technik bekannt ist. Der Lötstopplack auf der Unterseite des Trägerelements kann hierbei wahlweise vor dem Aufbringen der Kontaktkappen oder nach dem Aufbringen der Kontaktkappen aufgebracht werden. Der Lötstopplack an der Unterseite des Widerstands ist jedoch nur optional.

Darüber hinaus sieht das erfindungsgemäße Herstellungsverfahren vorzugsweise auch vor, dass ein Einschnitt in das flächige Trägerelement eingebracht wird, wobei der Einschnitt das flächige Trägerelement in zwei Teile trennt, so dass der Einschnitt einen Kurzschluss über das flächige Trägerelement verhindert. Diese Idee ist beispielsweise auch aus WO 2008/055582 A1 bekannt. Beispielsweise kann dieser Einschnitt V-förmig, W-förmig, senkrecht oder schräg zur Stromflussrichtung verlaufen, wie in der vorstehend erwähnten Druckschrift erläutert ist.

Darüber hinaus ist zu erwähnen, dass der Einschnitt in dem flächigen Trägerelement vorzugsweise mit einem elektrisch isolierenden Isolationsmaterial aufgefüllt wird. Zum einen ist dies vorteilhaft, weil dadurch die mechanische Belastbarkeit des Widerstands erhöht wird. Zum anderen ist die Auffüllung mit dem Isolationsmaterial aber auch vorteilhaft, um die Ableitung von elektrischer Verlustwärme zu verbessern.

Der Einschnitt wird vorzugsweise in das flächige Trägerelement eingebracht, bevor der Lötstopplack auf die Unterseite des flächigen Trägerelements aufgebracht wurde, so dass der Lötstopplack auch den Einschnitt mit dem darin befindlichen Isolationsmaterial abdeckt. Es ist jedoch alternativ auch möglich, dass kein Lötstopplack auf die Unterseite des Trägerelements aufgebracht wird.

Es wurde eingangs bereits kurz erwähnt, dass es sich bei dem flächigen Trägerelement vorzugsweise um eine Metallfolie handelt, wie beispielsweise eine Kupferfolie, die mit einer Widerstandsfolie als Widerstandselement verklebt wird.

Ferner ist allgemein zu erwähnen, dass die Kontaktkappen den Widerstand vorzugsweise an seiner Oberseite und an seiner Unterseite umgreifen. An der Unterseite des Widerstands können die Kontaktkappen bis zu dem Einschnitt in dem Trägerelement reichen.

Zu den im Rahmen der Erfindung verwendeten Begriffen einer Oberseite und einer Unterseite ist zu erwähnen, dass sich diese Begriffe nicht notwendiger Weise auf die räumliche Orientierung des Widerstands bei der Bestückung einer Leiterkarte beziehen. Vielmehr beziehen sich diese Begriffe lediglich auf die räumliche Orientierung des Trägerelements einerseits und des Widerstandselements andererseits.

Hinsichtlich des Widerstandsmaterials wurde vorstehend bereits kurz erwähnt, dass eine Kupfer-Mangan-Nickellegierung zum Einsatz kommen kann, wie beispielsweise eine Kupfer-Mangan-Nickel-Legierung. Insbesondere eignen sich die Legierungen CuMn12Ni (Manganin^{®}), CuMn7Sn oder CuMn3, um nur einige Beispiele zu erwähnen. Bei dem Widerstandsmaterial kann es sich doch auch um eine Nickel-Chrom-Legierung handeln, wie beispielsweise eine Nickel-Chrom-Aluminium-Legierung. Als Beispiele sind hier zu nennen NiCr20AlSiIMnFe, NiCr6015, NiCr8020, NiCr3020. Schließlich kann als Widerstandsmaterial auch eine Kupfer-Nickel-Legierung verwendet werden. Die Erfindung ist jedoch hinsichtlich des Widerstandsmaterials nicht auf die vorstehend genannten Beispiele beschränkt.

Die Dicke des flächigen Trägerelements und/oder des flächigen Widerstandselements ist vorzugsweise kleiner als 0,3 mm und größer als 0,5 mm.

Allgemein ist zu erwähnen, dass es sich bei dem Widerstand vorzugsweise um einen niederohmigen Strommesswiderstand handelt, der einen Widerstandswert im Milliohm-Bereich aufweist. Beispielsweise kann der Widerstandswert kleiner sein als 500 mΩ, 200 mΩ, 50mΩ, 30mΩ, 20mΩ, 10mΩ, 5mΩ oder 1mΩ.

Ferner ist noch allgemein zu erwähnen, dass es sich bei dem Widerstand vorzugsweise um einen SMD-Widerstand (SMD: Surface mounted device) handelt.

Neben dem vorstehend beschriebenen erfindungsgemäßen Herstellungsverfahren beansprucht die Erfindung auch Schutz für einen entsprechend hergestellten Widerstand. Hierbei ist zu erwähnen, dass sich der fertige Widerstand dadurch auszeichnet, dass er keinen Trimmschnitt in dem Widerstandselement enthält und der Abstand zwischen den Kontaktkappen variiert.

Andere vorteilhafte Weiterbildungen der Erfindung sind in den Unteransprüchen gekennzeichnet oder werden nachstehend zusammen mit der Beschreibung der bevorzugten Ausführungsbeispiele der Erfindung anhand der Figuren näher erläutert.

### Kurzbeschreibung der Zeichnungen

Figur 1A zeigt eine Querschnittsansicht durch einen erfindungsgemäßen Strommesswiderstand.
Figur 1B zeigt ein Flussdiagramm zur Verdeutlichung des Herstellungsverfahrens des Stromesswiderstands gemäß Figur 1A.
Figur 2A zeigt eine Abwandlung von Figur 1A.
Figur 2B zeigt ein Flussdiagramm zur Verdeutlichung des Herstellungsverfahrens des Stromesswiderstands gemäß Figur 2A.

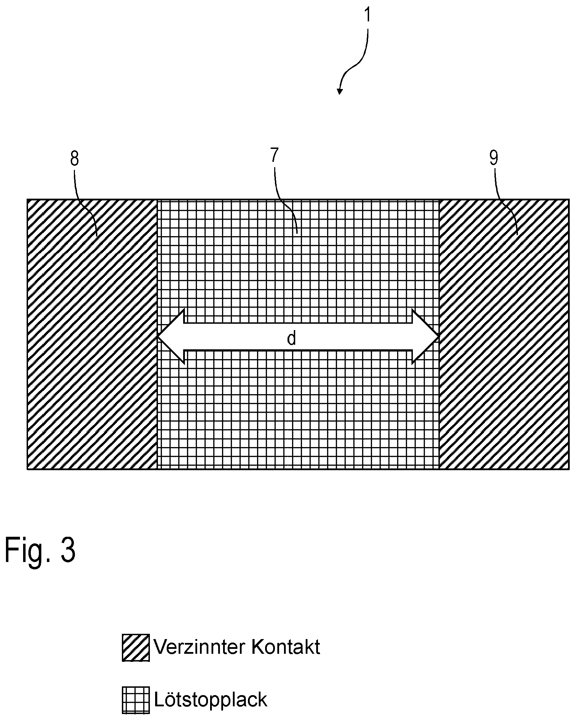

Figur 3 zeigt eine Aufsicht auf die Stromesswiderstände gemäß den Figuren 1A und 2A.

### Detaillierte Beschreibung der Zeichnungen

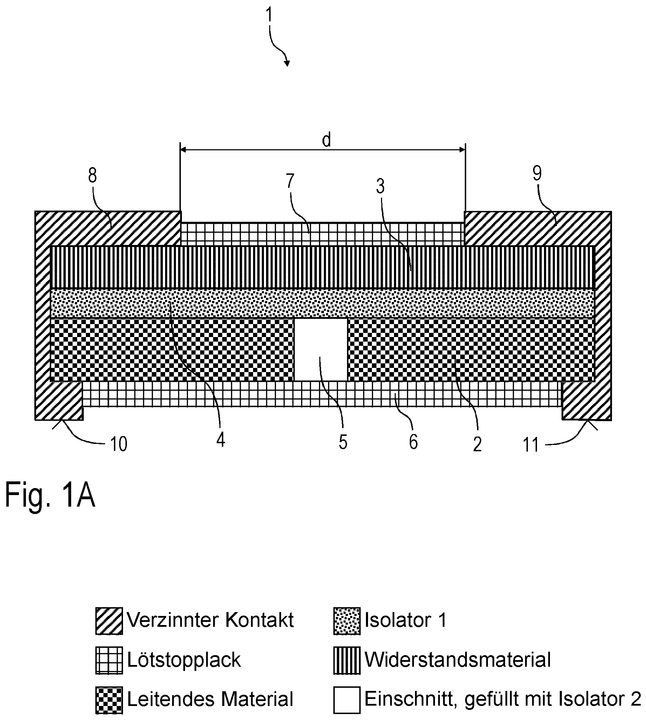

Im Folgenden wird nun zunächst das in Figur 1A dargestellte Ausführungsbeispiel eines erfindungsgemäßen Strommesswiderstands 1 beschrieben. Der Aufbau und das technische Prinzip des Strommesswiderstands 1 stimmt weitgehend mit dem bekannten Strommesswiderstand überein, wie er in WO 2008/055582 A1 beschrieben ist, so dass der Inhalt dieser Druckschrift der vorliegenden Beschreibung in vollem Umfang zuzurechnen ist. Im Folgenden wird der Strommesswiderstand 1 deshalb nur kurz beschrieben, um anschließend auf die erfindungsgemäßen Einzelheiten des Abgleichs des Widerstandswerts einzugehen.

Der Strommesswiderstand 1 weist zunächst ein Trägerelement 2 auf, das in diesem Ausführungsbeispiel aus einer Kupferfolie hergestellt ist.

Darüber hinaus weist der Strommesswiderstand 1 ein Widerstandselement 3 auf, das in diesem Ausführungsbeispiel aus einer Widerstandsfolie hergestellt ist.

Das Trägerelement 2 ist durch eine Klebstoffschicht 4 mit dem Widerstandselement 3 verklebt, wie es an sich aus dem Stand der Technik bekannt ist. Die Klebstoffschicht 4 hierbei zwei Funktionen. Zum einen verbindet die Klebstoffschicht 4 das Widerstandselement 3 mechanisch mit dem Trägerelement 2. Zum anderen bildet die Klebstoffschicht 4 aber auch eine elektrische Isolation zwischen dem Widerstandselement 3 und dem Trägerelement 2.

In dem metallischen Trägerelement 2 befindet sich hierbei ein Einschnitt 5, um in dem fertigen Stromesswiderstand 1 einen elektrischen Kurzschluss über das metallische Trägerelement 2 zu verhindern. Der Einschnitt 5 in dem Trägerelement 2 ist mit einem Isolationsmaterial gefüllt. Zum einen verbessert die Auffüllung des Einschnitts 5 mit dem Isolationsmaterial die mechanische Belastbarkeit des fertigen Stromesswiderstands 1. Zum anderen verbessert die Auffüllung des Einschnitts 5 mit dem Isolationsmaterial auch die Wärmeableitung innerhalb des Strommesswiderstands 1.

Auf die Unterseite des Stromesswiderstands 1 ist ein Lötstopplack 6 aufgebracht.

Darüber hinaus ist auch auf die Oberseite des Widerstandselements 3 ein Lötstopplack 7 aufgebracht, wobei der Lötstopplack 7 an der Oberseite des Widerstandselements 3 eine Ausdehnung d entlang der Stromflussrichtung in dem fertigen Strommesswiderstand 1 aufweist.

Ferner weist der Stromesswiderstand 1 an seinen in Stromflussrichtung gegenüberliegenden Enden zwei Kontaktkappen 8, 9 auf, die zur elektrischen Kontaktierung des Strommesswiderstands 1 dienen. Die Kontaktkappen 8, 9 umgreifen den Strommesswiderstand 1 hierbei seitlich sowohl an der Oberseite als auch an der Unterseite. An der Oberseite erreichen die beiden Kontaktkappen 8, 9 bis an den Lötstopplack 7 heran. Dies bedeutet, dass die Ausdehnung d des Lötstopplacks 7 den Abstand zwischen den beiden Kontaktkappen 8, 9 definiert. Dies ist von Bedeutung, weil der Abstand d zwischen den beiden Kontaktkappen 8, 9 die Länge des Stromwegs definiert, der zwischen den beiden Kontaktkappen 8, 9 durch das Widerstandselement 3 verläuft. Damit definiert der Abstand d zwischen den beiden Kontaktkappen 8, 9 auch den Widerstandswert. Im Rahmen des Erfindungsgemäßen Verfahrens zum Abgleich des Widerstandswerts wird die Ausdehnung d des Lötstopplack 7 deshalb hochpräzise eingestellt und zwar in Abhängigkeit von dem gewünschten Widerstandswert des fertigen Stromesswiderstands 1.

Schließlich ist noch zu erwähnen, dass der Strommesswiderstand 1 an seiner Unterseite Kontaktierungsflächen 10, 11 aufweist, an denen der Strommesswiderstand 1 beispielsweise auf einer Leiterkarte kontaktiert werden kann.

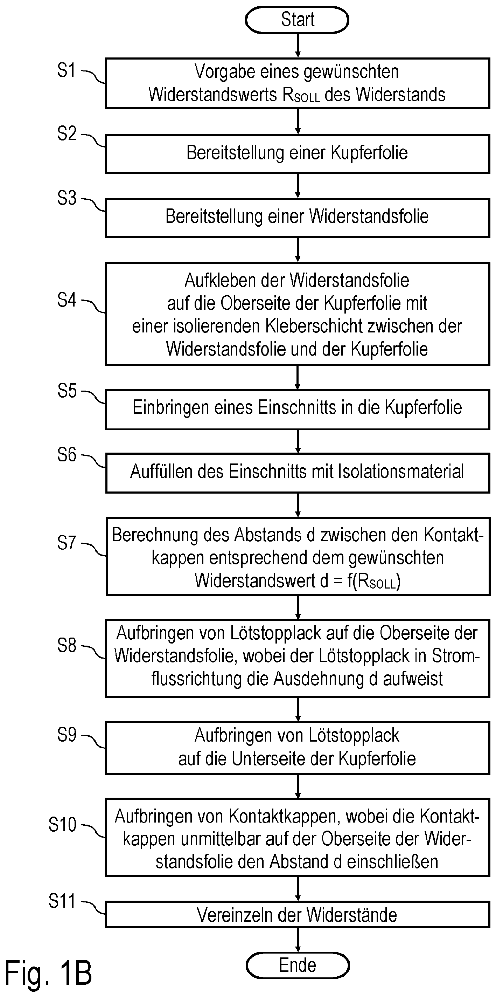

Im Folgenden wird nun das Flussdiagramm gemäß Figur 1B beschrieben, welches das Herstellungsverfahrens des Stromesswiderstands 1 gemäß Figur 1A verdeutlicht.

In einem ersten Schritt S1 wird zunächst ein gewünschter Widerstandswert R_{SOLL} für den Strommesswiderstand 1 vorgegeben.

In einem Schritt S2 wird das Trägerelement 2 dann in Form einer Kupferfolie bereitgestellt.

In dem Schritt S3 wird dann das Widerstandselement 3 in Form einer Widerstandsfolie bereitgestellt.

Der nächste Schritt S4 sieht dann vor, dass die Widerstandsfolie auf die Oberseite der Kupferfolie aufgeklebt wird und zwar mit der elektrisch isolierenden Klebstoffschicht 4 zwischen dem Trägerelement 2 und dem Widerstandselement 3.

Im nächsten Schritt S5 wird dann der Einschnitt 5 in die Kupferfolie eingebracht, die das Trägerelement 2 bildet.

In einem nächsten Schritt S6 wird der Einschnitt 5 dann mit dem Isolationsmaterial aufgefüllt.

In einem Schritt S7 wird dann in Abhängigkeit von dem gewünschten Widerstandswert R_{SOLL} berechnet, wie groß der Abstand d zwischen den Kontaktkappen 8, 9 sein muss, damit der gewünschte Widerstandswert R_{SOLL} möglichst exakt eingehalten wird.

Im nächsten Schritt S8 wird dann der Lötstopplack 7 auf die Oberseite der Widerstandsfolie aufgebracht, wobei die Ausdehnung d des Lötstopplacks 7 möglichst exakt eingehalten wird. Das Aufbringen des Lötstopplacks 7 auf die Oberseite der Widerstandsfolie erfolgt also mit einer großen Positionierungsgenauigkeit, damit die gewünschte Ausdehnung d möglichst exakt eingehalten wird.

Im nächsten Schritt S9 wird dann noch der Lötstopplack 6 auf die Unterseite der Kupferfolie aufgebracht.

In einem Schritt S10 werden dann die gegenüberliegenden Kontaktkappen 8, 9 aufgebracht, wobei sich dann unmittelbar an der Oberseite der Widerstandsfolie der gewünschte Abstand d zwischen den Kontaktkappen 8, 9 einstellt. Das Aufbringen der Kontaktkappen 8, 9 muss also nicht mit einer großen Positionierungsgenauigkeit erfolgen, da der Abstand d zuvor durch die Ausdehnung des Lötstopplacks 7 eingestellt wurde.

In einem nächsten Schritt S11 erfolgt dann ein Vereinzeln der Stromesswiderstände 1.

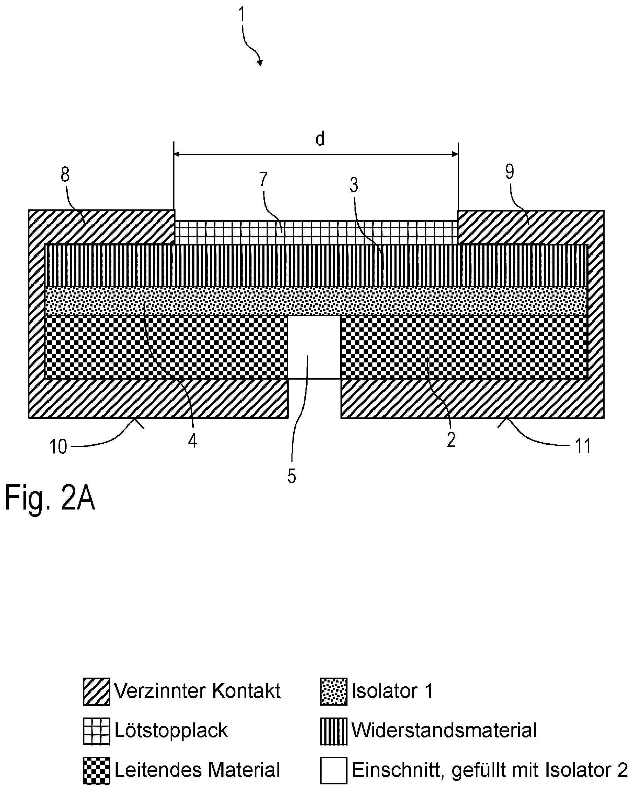

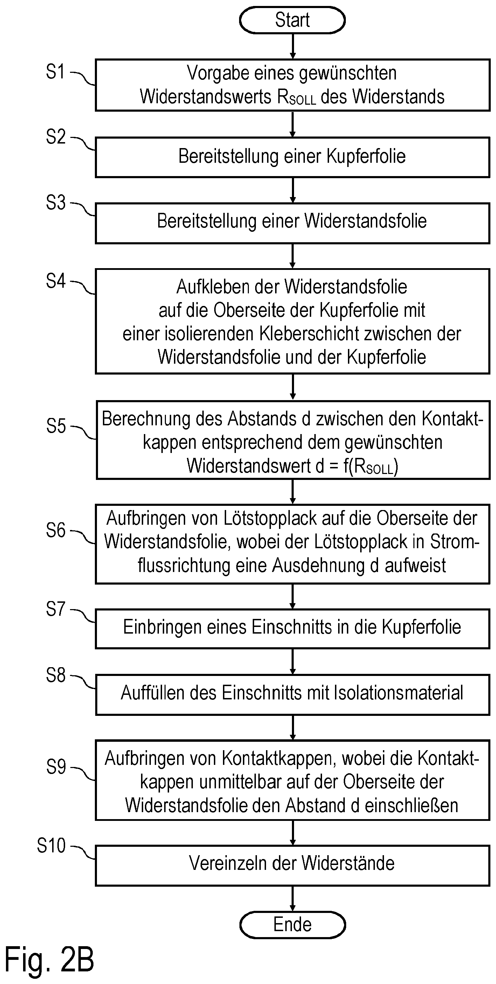

Das Ausführungsbeispiel gemäß den Figuren 2A und 2B stimmt weitgehend mit dem Ausführungsbeispiel gemäß den Figuren 1A und 1B überein, so dass zur Vermeidung von Wiederholungen auf die vorstehende Beschreibung verwiesen wird.

Eine Besonderheit dieses Ausführungsbeispiels besteht darin, dass auf die Unterseite des Strommesswiderstands 1 kein Lötstopplack aufgebracht wird.

Eine weitere Besonderheit dieses Ausführungsbeispiels besteht darin, dass die Kontaktkappen 8, 9 an der Unterseite des Stromesswiderstand 1 nach innen bis zu dem Einschnitt 5 reichen.

Ansonsten wird zur Vermeidung von Wiederholungen auf die vorstehende Beschreibung verwiesen.

### Bezugszeichenliste:

- 1: Strommesswiderstand
- 2: Trägerelement aus einer Kupferfolie
- 3: Widerstandselement aus einer Widerstandsfolie
- 4: Klebstoffschicht
- 5: Einschnitt in dem Trägerelement
- 6: Lötstopplack an der Unterseite
- 7: Löttopplack an der Oberseite
- 8, 9: Kontaktkappen des Strommesswiderstands
- 10, 11: Kontaktierungsflächen der Kontaktkappen an der Unterseite des Strommesswiderstands
- d: Abstand zwischen den Kontaktkappen

## Patentansprüche

1. Herstellungsverfahren für einen elektrischen Widerstand (1), insbesondere für einen niederohmigen Strommesswiderstand, mit den folgenden Schritten:
a) Bereitstellung eines flächigen Trägerelements (2) mit einer Oberseite und einer Unterseite,
b) Bereitstellung eines flächigen Widerstandselements (3) aus einem Widerstandsmaterial,
c) flächiges Aufbringen des flächigen Widerstandselements (3) auf die Oberseite des flächigen Trägerelements (2), und
d) elektrische Kontaktierung des flächigen Widerstandselements (3) durch zwei Kontaktkappen (8, 9), wobei die beiden Kontaktkappen (8, 9)
d1) aus einem elektrisch leitfähigen Leitermaterial bestehen,
d2) auf der Oberseite des Widerstandselements (3) unmittelbar aufliegen,
d3) bezüglich der Stromflussrichtung in dem Widerstand (1) einander gegenüberliegen, und
d4) entlang der Stromflussrichtung in dem Widerstand (1) unmittelbar auf der Oberseite des flächigen Widerstandselements (3) einen bestimmten Abstand (d) zwischen sich einschließen, und
e) Vorgabe eines gewünschten Widerstandswerts (R_{SOLL}) des Widerstands (1),
f) Aufbringen von Lötstopplack (7) unmittelbar auf die Oberseite des Widerstandselements (3) vor der Kontaktierung durch die Kontaktkappen (8, 9),
f1) wobei der Lötstopplack (7) eine bestimmte Ausdehnung (d) entlang der Stromflussrichtung in dem Widerstand (1) aufweist,
f2) wobei beim Aufbringen des Lötstopplacks (7) auf die Oberseite des Widerstandselements (3) die Ausdehnung (d) des Lötstopplacks (7) entlang der Stromflussrichtung in dem Widerstand (1) mit einer ersten Positionierungsgenauigkeit eingestellt wird, und
g) Aufbringen der Kontaktkappen (8, 9) auf die Oberseite des flächigen Widerstandselements (3) nach dem Aufbringen des Lötstopplacks (7) auf die Oberseite des Widerstandselements (3),
g1) so dass die Ausdehnung (d) des Lötstopplacks (7) definiert, welchen Abstand (d) die Kontaktkappen (8, 9) unmittelbar an der Oberseite des Widerstandselements (3) haben,
g2) wobei beim Aufbringen der Kontaktkappen (8, 9) der Abstand (d) zwischen den Kontaktkappen (8, 9) entlang der Stromflussrichtung in dem Widerstand (1) mit einer zweiten Positionierungsgenauigkeit eingestellt wird,
**dadurch gekennzeichnet,**
h) **dass** ein Abgleichen des Widerstandswerts des Widerstands (1) durch eine Einstellung des Abstands (d) zwischen den Kontaktkappen (8, 9) unmittelbar an der Oberseite des Widerstandselements (3) erfolgt, wobei der Abstand (d) in Abhängigkeit von dem gewünschten Widerstandswert (R_{SOLL}) eingestellt wird, und
i) **dass** die erste Positionierungsgenauigkeit größer ist als die zweite Positionierungsgenauigkeit.

2. Herstellungsverfahren nach Anspruch 1, **dadurch gekennzeichnet,**
a) **dass** das Trägerelement (2) aus einem elektrisch leitfähigen Leitermaterial besteht, und
b) **dass** das Widerstandselement (3) auf die Oberseite des flächigen Trägerelements (2) aufgebracht wird mit einer elektrisch isolierenden Schicht (4) zwischen dem flächigen Widerstandselement (3) und dem flächigen Trägerelement (2).

3. Herstellungsverfahren nach einem der vorhergehenden Ansprüche, **gekennzeichnet durch** folgenden Schritt:
Aufbringen von Lötstopplack (6) auf die Unterseite des flächigen Trägerelements (2) zwischen den Kontaktkappen (8, 9).

4. Herstellungsverfahren nach Anspruch 3, **dadurch gekennzeichnet, dass** der Lötstopplack (6) auf die Unterseite des flächigen Trägerelements (2) aufgebracht wird,
a) bevor die Kontaktkappen (8, 9) auf den Widerstand (1) aufgebracht werden oder
b) nachdem die Kontaktkappen (8, 9) auf den Widerstand (1) aufgebracht wurden.

5. Herstellungsverfahren nach einem der vorhergehenden Ansprüche, **gekennzeichnet durch** folgenden Schritt:
Einbringen eines Einschnitts (5) in das flächige Trägerelement (2), wobei der Einschnitt (5) das flächige Trägerelement (2) in zwei Teile trennt, so dass der Einschnitt (5) einen Kurzschluss über das flächige Trägerelement (2) verhindert.

6. Herstellungsverfahren nach Anspruch 5, **gekennzeichnet durch** folgenden Schritt:
Auffüllen des Einschnitts (5) mit einem elektrischen isolierenden Isolationsmaterial.

7. Herstellungsverfahren nach Anspruch 5 oder 6, **dadurch gekennzeichnet, dass**, wenn auf die Unterseite ebenfalls der Lötstopplack (6) aufgebracht wird, der Einschnitt (5) in das flächige Trägerelement (2) eingebracht wird, bevor der Lötstopplack (6) auf die Unterseite des flächigen Trägerelements (2) aufgebracht wird, so dass der Lötstopplack (6) auch den Einschnitt (5) abdeckt.

8. Herstellungsverfahren nach einem der vorhergehenden Ansprüche,
**dadurch gekennzeichnet,**
a) **dass** das flächige Trägerelement (2) aus einer Metallfolie hergestellt wird, insbesondere aus einer Kupferfolie,
b) **dass** das flächige Widerstandselement (3) aus einer Widerstandsfolie hergestellt wird, und
c) **dass** die Metallfolie durch eine Klebstoffschicht (4) flächig mit der Widerstandsfolie verklebt wird, wobei die Klebstoffschicht (4) die elektrisch isolierende Schicht bildet.

9. Herstellungsverfahren nach einem der vorhergehenden Ansprüche,
**dadurch gekennzeichnet,**
a) **dass** die Kontaktkappen (8, 9) den Widerstand (1) an seiner Oberseite und an seiner Unterseite umgreifen, und/oder
b) **dass** die Kontaktkappen (8, 9) an der Unterseite des Widerstands (1) bis zu dem Einschnitt (5) in dem Trägerelement (2) reichen, und/oder
c) **dass** das Leitermaterial der Kontaktkappen (8, 9) Zinn enthält.

10. Herstellungsverfahren nach einem der vorhergehenden Ansprüche,
**dadurch gekennzeichnet,**
a) **dass** das Widerstandsmaterial eines der folgenden Materialien ist:
a1) eine Kupfer-Mangan-Legierung, insbesondere Kupfer-Mangan-Nickel-Legierung, insbesondere CuMn12Ni, CuMn7Sn oder CuMn3,
a2) eine Nickel-Chrom-Legierung, insbesondere Nickel-Chrom-Aluminium-Legierung, insbesondere NiCr20AlSiIMnFe, NiCr6015, NiCr8020, NiCr3020,
a3) eine Kupfer-Nickel-Legierung, und/oder
b) **dass** das flächige Trägerelement (2) eine Dicke aufweist, die kleiner als 0,3 mm und/oder größer als 0,5 mm ist, und/oder
c) **dass** das flächige Widerstandselement (3) eine Dicke aufweist, die kleiner als 0,3 mm und/oder größer als 0,05 mm ist, und/oder
d) **dass** das Leitermaterial der Kontaktkappen (8, 9) Kupfer, eine Kupferlegierung, Aluminium oder eine Aluminiumlegierung ist, und/oder
e) **dass** der Widerstand (1) einen Widerstandswert im Milliohm-Bereich aufweist, insbesondere einen Widerstandswert von weniger als 500 mΩ, 200 m2, 50mΩ, 30mΩ, 20mΩ, 10mΩ, 5mΩ oder 1mΩ, und/oder
f) **dass** das Widerstandsmaterial einen größeren spezifischen elektrischen Widerstand (1) aufweist als das Leitermaterial, und/oder
g) **dass** der Widerstand (1) ein SMD-Widerstand (1) ist.

11. Widerstand (1), der mit dem Herstellungsverfahren nach einem der vorhergehenden Ansprüche hergestellt wurde.

12. Widerstand (1) nach Anspruch 11, **dadurch gekennzeichnet, dass** der Widerstand (1) keinen Trimmschnitt in dem Widerstandselement (3) enthält.

## Claims

1. Manufacturing method for an electrical resistor (1), in particular for a low-impedance current measuring resistor, comprising the following steps:
a) provision of a flat support element (2) with an upper side and a lower side,
b) providing a flat resistor element (3) made of a resistor material,
c) flat application of the flat resistor element (3) to the upper side of the flat support element (2), and
d) electrical contacting of the flat resistor element (3) by two contact caps (8, 9), wherein the two contact caps (8, 9)
d1) consist of an electrically conductive conductor material,
d2) rest directly on the upper side of the resistor element (3),
d3) lie opposite one another with respect to the direction of current flow in the resistor (1), and
d4) enclose a certain distance (d) between them along the direction of current flow in the resistor (1) directly on the upper side of the flat resistor element (3), and
e) setting a desired resistance value (R_{SOLL}) of the resistor (1),
f) applying solder resist (7) directly to the upper side of the resistor element (3) before contacting by the contact caps (8, 9),
f1) wherein the solder resist (7) has a certain extension (d) along the direction of current flow in the resistor (1),
f2) wherein, when the solder resist (7) is applied to the upper side of the resistor element (3), the extension (d) of the solder resist (7) along the direction of current flow in the resistor (1) is set with a first positioning accuracy, and
g) application of the contact caps (8, 9) to the upper side of the flat resistor element (3) after application of the solder resist (7) to the upper side of the resistor element (3),
g1) so that the extension (d) of the solder resist (7) defines the distance (d) of the contact caps (8, 9) directly on the upper side of the resistor element (3),
g2) wherein, when the contact caps (8, 9) are applied, the distance (d) between the contact caps (8, 9) along the direction of current flow in the resistor (1) is set with a second positioning accuracy,
**characterised in**
h) **that** an adjustment of the resistance value of the resistor (1) is made by adjusting the distance (d) between the contact caps (8, 9) directly on the upper side of the resistor element (3), the distance (d) being adjusted as a function of the desired resistance value (R_{SOLL}), and
i) **that** the first positioning accuracy is greater than the second positioning accuracy.

2. Manufacturing method according to claim 1, **characterised in**
a) **that** the flat support element (2) is made of an electrically conductive conductor material, and
b) **that** the flat resistor element (3) is applied to the upper side of the flat support element (2) with an electrically insulating layer (4) between the flat resistor element (3) and the flat support element (4).

3. Manufacturing method according to one of the preceding claims, **characterised by** the following step:
Applying solder resist (6) to the underside of the flat support element (2) between the contact caps (8, 9).

4. Manufacturing method according to claim 3, **characterised in that** the solder resist (6) is applied to the underside of the flat support element (2),
a) before the contact caps (8, 9) are applied to the resistor (1) or
b) after the contact caps (8, 9) have been applied to the resistor (1).

5. Manufacturing method according to one of the preceding claims, **characterised by** the following step:
Making an incision (5) in the flat support element (2), wherein the incision (5) separates the flat support element (2) into two parts, so that the incision (5) prevents a short circuit across the flat support element (2).

6. Manufacturing method according to claim 5, **characterised by** the following step:
Filling the incision (5) with an electrically insulating insulating material.

7. Manufacturing method according to claim 5 or 6, **characterised in that,** when the solder resist (6) is applied to the underside of the flat support element (2), the incision (5) is made in the flat support element (2) before the solder resist (6) is applied to the underside of the flat support element (2), so that the solder resist (6) also covers the incision (5).

8. Manufacturing method according to one of the preceding claims, **characterised in**
a) **that** the flat support element (2) is produced from a metal foil, in particular from a copper foil,
b) **that** the flat resistor element (3) is produced from a resistance foil, and
c) **that** the metal foil is bonded to the resistance foil over its entire surface by an adhesive layer (4), the adhesive layer (4) forming the electrically insulating layer.

9. Manufacturing method according to one of the preceding claims, **characterised in**
a) **that** the contact caps (8, 9) embrace the resistor (1) on its upper side and on its lower side, and/or
b) **that** the contact caps (8, 9) on the underside of the resistor (1) extend as far as the incision (5) in the support element (2), and/or
c) **that** the conductor material of the contact caps (8, 9) contains tin.

10. Manufacturing method according to one of the preceding claims, **characterised in**
a) **that** the resistor material is one of the following materials:
a1) a copper-manganese alloy, in particular a copper-manganese-nickel alloy, in particular CuMn12Ni, CuMn7Sn or CuMn3,
a2) a nickel-chromium alloy, in particular a nickel-chromium-aluminium alloy, in particular NiCr20AlSilMnFe, NiCr6015, NiCr8020, NiCr3020,
a3) a copper-nickel alloy, and/or
b) **that** the flat support element (2) has a thickness which is less than 0.3 mm and/or greater than 0.5 mm, and/or
c) **that** the flat resistor element (3) has a thickness which is less than 0.3 mm and/or greater than 0.05 mm, and/or
d) **that** the conductor material of the contact caps (8, 9) is copper, a copper alloy, aluminium or an aluminium alloy, and/or
e) **that** the resistor (1) has a resistance value in the milliohm range, in particular a resistance value of less than 500 mΩ, 200 mΩ, 50mΩ, 30mΩ, 20mΩ, 10mΩ, 5mΩ or 1mΩ, and/or
f) **that** the resistor material has a greater specific electrical resistance (1) than the conductor material, and/or
g) **that** the resistor (1) is an SMD resistor (1).

11. Resistor (1) manufactured by the manufacturing method according to any of the preceding claims.

12. Resistor (1) according to claim 11, **characterised in that** the resistor (1) does not include a trim cut in the resistor element (3).

## Revendications

1. Procédé de fabrication d'une résistance (1) électrique, en particulier d'une résistance de mesure de courant à basse impédance, avec les étapes suivantes:
a) la mise à disposition d'un élément porteur (2) plat avec une face supérieure et une face inférieure,
b) la mise à disposition d'un élément de résistance (3) plat composé d'un matériau de résistance,
c) l'application à plat de l'élément de résistance (3) plat sur la face supérieure de l'élément porteur (2) plat, et
d) la mise en contact électrique de l'élément de résistance (3) plat par deux capuchons de contact (8, 9), dans lequel les deux capuchons de contact (8, 9)
d1) sont constitués d'un matériau conducteur électriquement conducteur,
d2) reposent directement sur la face supérieure de l'élément de résistance (3),
d3) sont opposés l'un à l'autre par rapport à la direction du flux de courant dans la résistance (1), et
d4) renferment une certaine distance (d) entre eux le long de la direction du flux de courant dans la résistance (1) directement sur la face supérieure de l'élément de résistance (3) plat, et
e) la spécification d'une valeur de résistance souhaitée (R_{CONSIGNE}) de la résistance (1),
f) l'application d'un masque de soudure (7) directement sur la face supérieure de l'élément de résistance (3) avant la mise en contact par les capuchons de contact (8, 9),
f1) dans lequel le masque de soudure (7) présente une certaine extension (d) le long de la direction du flux de courant dans la résistance (1),
f2) dans lequel, lors de l'application du masque de soudure (7) sur la face supérieure de l'élément de résistance (3), l'extension (d) du masque de soudure (7) est réglée le long de la direction du flux de courant dans la résistance (1) avec une première précision de positionnement, et
g) l'application des capuchons de contact (8, 9) sur la face supérieure de l'élément de résistance (3) plat après l'application du masque de soudure (7) sur la face supérieure de l'élément de résistance (3),
g1) de telle sorte que l'extension (d) du masque de soudure (7) définit la distance (d) que les capuchons de contact (8, 9) présentent directement sur la face supérieure de l'élément de résistance (3),
g2) dans lequel, lors de l'application des capuchons de contact (8, 9), la distance (d) entre les capuchons de contact (8, 9) est réglée le long de la direction du flux de courant dans la résistance (1) avec une deuxième précision de positionnement,
**caractérisé en ce**
h) **qu'**un équilibrage de la valeur de résistance de la résistance (1) est effectué par un réglage de la distance (d) entre les capuchons de contact (8, 9) directement sur la face supérieure de l'élément de résistance (3), dans lequel la distance (d) est réglée en fonction de la valeur de résistance souhaitée (R_{CONSIGNE}), et
i) **que** la première précision de positionnement est supérieure à la deuxième précision de positionnement.

2. Procédé de fabrication selon la revendication 1, **caractérisé en ce**
a) **que** l'élément porteur (2) est constitué d'un matériau conducteur électriquement conducteur, et
b) **que** l'élément de résistance (3) est appliqué sur la face supérieure de l'élément porteur (2) plat avec une couche électriquement isolante (4) entre l'élément de résistance (3) plat et l'élément porteur (2) plat.

3. Procédé de fabrication selon l'une quelconque des revendications précédentes, **caractérisé par** l'étape suivante:
l'application du masque de soudure (6) sur la face inférieure de l'élément porteur (2) plat entre les capuchons de contact (8, 9).

4. Procédé de fabrication selon la revendication 3, **caractérisé en ce que** le masque de soudure (6) est appliqué sur la face inférieure de l'élément porteur (2) plat,
a) avant que les capuchons de contact (8, 9) ne soient appliqués sur la résistance (1) ou
b) après que les capuchons de contact (8, 9) ont été appliqués sur la résistance (1).

5. Procédé de fabrication selon l'une quelconque des revendications précédentes, **caractérisé par** l'étape suivante:
la réalisation d'une incision (5) dans l'élément porteur (2) plat, dans lequel l'incision (5) sépare l'élément porteur (2) plat en deux parties de telle sorte que l'incision (5) empêche un court-circuit par l'élément porteur (2) plat.

6. Procédé de fabrication selon la revendication 5, **caractérisé par** l'étape suivante:
le remplissage de l'incision (5) avec un matériau électriquement isolant.

7. Procédé de fabrication selon la revendication 5 ou 6, **caractérisé en ce que**, lorsque le masque de soudure (6) est également appliqué sur la face inférieure, l'incision (5) est réalisée dans l'élément porteur (2) plat avant que le masque de soudure (6) ne soit appliqué sur la face inférieure de l'élément porteur (2) plat, de telle sorte que le masque de soudure (6) recouvre également l'incision (5).

8. Procédé de fabrication selon l'une quelconque des revendications précédentes,
**caractérisé en ce**
a) **que** l'élément porteur (2) plat est fabriqué à partir d'un film métallique, en particulier d'un film de cuivre,
b) **que** l'élément de résistance (3) plat est fabriqué à partir d'un film de résistance, et
c) **que** le film métallique est collé à plat au film de résistance par une couche adhésive (4), dans lequel la couche adhésive (4) forme la couche électriquement isolante.

9. Procédé de fabrication selon l'une quelconque des revendications précédentes,
**caractérisé en ce**
a) **que** les capuchons de contact (8, 9) enserrent la résistance (1) sur sa face supérieure et sur sa face inférieure, et/ou
b) **que** les capuchons de contact (8, 9) atteignent sur la face inférieure de la résistance (1) l'incision (5) dans l'élément porteur (2), et/ou
c) **que** le matériau conducteur des capuchons de contact (8, 9) contient de l'étain.

10. Procédé de fabrication selon l'une quelconque des revendications précédentes,
**caractérisé en ce**
a) **que** le matériau de résistance est l'un des matériaux suivants:
a1) un alliage cuivre-manganèse, en particulier un alliage cuivre-manganèse-nickel, en particulier CuMn12Ni, CuMn7Sn ou CuMn3,
a2) un alliage nickel-chrome, en particulier un alliage nickel-chrome-aluminium, en particulier NiCr20AlSilM-nFe, NiCr6015, NiCr8020, NiCr3020,
a3) un alliage cuivre-nickel, et/ou
b) **que** l'élément porteur (2) plat présente une épaisseur inférieure à 0,3 mm et/ou supérieure à 0,5 mm, et/ou
c) **que** l'élément de résistance (3) plat présente une épaisseur inférieure à 0,3 mm et/ou supérieure à 0,05 mm, et/ou
d) **que** le matériau conducteur des capuchons de contact (8, 9) est du cuivre, un alliage de cuivre, de l'aluminium ou un alliage d'aluminium, et/ou
e) **que** la résistance (1) présente une valeur de résistance dans la plage des milliohms, en particulier une valeur de résistance inférieure à 500 mΩ, 200 mΩ, 50 mΩ, 30 mΩ, 20 mΩ, 10 mΩ, 5 mΩ ou 1 mΩ, et/ou
f) **que** le matériau de résistance présente une résistance (1) électrique spécifique supérieure au matériau conducteur, et/ou
g) **que** la résistance (1) est une résistance SMD (1).

11. Résistance (1), qui a été fabriquée avec le procédé de fabrication selon l'une quelconque des revendications précédentes.

12. Résistance (1) selon la revendication 11, **caractérisée en ce que** la résistance (1) ne contient pas de coupe d'ajustement dans l'élément de résistance (3).
